# FASCICULE DE BREVET EUROPEEN

(11) **EP 1 012 972 B1**
(45) Date de publication et mention de la délivrance du brevet: **23.01.2002**
(21) Numéro de dépôt: 98942833.9
(22) Date de dépôt: 07.09.1998
(51) Int. Cl.: H03K 3/84

(54) **GENERATEUR D'ALEA**
ZUFALLSGENERATOR
RANDOM SIGNAL GENERATOR

(30) Priorité: 10.09.1997 FR 9711210
(43) Date de publication de la demande: 28.06.2000
(73) Titulaire: Inside technologies, 69930 Saint-Clément-les-Places (FR)
(72) Inventeur: KOWALSKI, Jacek, F-13090 Aix en Provence (FR)
(74) Mandataire: Marchand, André
(86) Numéro de dépôt international: FR9801907
(87) Numéro de publication internationale: WO9913572

(56) Documents cités:
- FR-A- 2 390 047
- US-A- 4 183 088
- DATABASE WPI Section EI, Week 8548 Derwent Publications Ltd., London, GB; Class U22, AN 85-301821 XP002065767 & SU 1 157 671 A (KAZAN AVIATION INST) , 23 mai 1985

## Description

La présente invention concerne un générateur de signal aléatoire.

Dans le domaine de l'électronique, et notamment celui des cartes à puce, il est parfois nécessaire de disposer d'un moyen permettant de générer un signal logique aléatoire, c'est-à-dire un signal comprenant une séquence aléatoire de bits à "1" ou à "0".

Par exemple, au cours d'une procédure d'authentification classique d'un lecteur de carte à puce, une carte à puce envoie au lecteur un signal aléatoire, ou ALEA, du type évoqué ci-dessus, comprenant par exemple 16 ou 32 bits. La carte à puce calcule le résultat R = F_{Ks}(ALEA) de la transformation de l'ALEA par une fonction d'authentification F_{Ks} à clef secrète Ks. Le terminal effectue, de son côté, le même calcul et renvoie à la carte un résultat R'. Si les résultats R et R' sont identiques, la carte considère le terminal comme authentique et accepte de procéder à la transaction demandée.

Dans l'art antérieur, certains générateurs d'aléas à logique câblée prennent la forme d'une machine logique (ou automate cellulaire) comportant un nombre fini d'états internes. Il peut s'agir par exemple d'un registre à décalage dont certains bits sont renvoyés en entrée par l'intermédiaire d'une porte OU Exclusif. A partir d'un état interne initial, on active la machine logique au moyen d'un signal d'horloge et l'on extrait, à chaque coup d'horloge, un bit interne de la machine logique.

L'inconvénient de ces machines logiques est qu'elles présentent généralement un taux élevé de répétitivité des séquences de bits qu'elles produisent, ainsi qu'un biais statistique de sortie portant sur la répartition des "1" et des "0". Pour pallier cet inconvénient, on doit prévoir des machines logiques présentant un très grand nombre d'états internes, l'idéal théorique étant que la machine présente un nombre infini d'états internes. Toutefois, cette solution va à l'encontre des exigences de simplicité, de faible coût de revient et de faible consommation des générateurs d'aléas.

Par ailleurs, on connaît des générateurs aléatoires utilisant le bruit électronique comme source de signal aléatoire. En effet, le bruit électronique est, par nature, essentiellement aléatoire. De plus, le bruit électronique est présent dans tous les circuits électroniques du fait de l'agitation thermoélectronique présente dans les composants électroniques et des bruits de commutation de transistors. Il est donc aisé de réaliser une source de bruit électronique, par exemple au moyen d'un composant électronique ou, plus simplement encore, en prélevant le bruit électronique présent à l'intérieur d'un circuit.

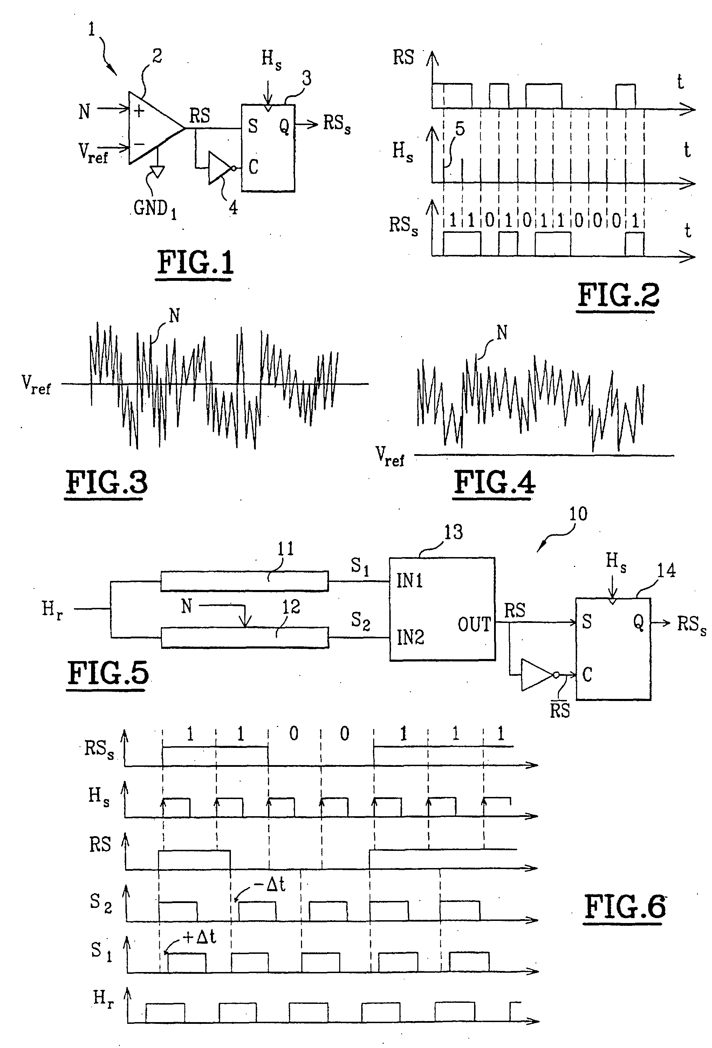

La figure 1 représente schématiquement un générateur aléatoire 1 classique fonctionnant à partir d'une source de bruit électronique N. Le générateur 1 comprend un comparateur 2 de gain théorique infini recevant le bruit électronique N sur son entrée positive et une tension de référence Vref sur son entrée négative. La sortie du comparateur 2 délivre un signal logique aléatoire RS. Le signal RS est appliqué à un circuit échantillonneur 3 qui délivre un signal aléatoire RSs synchronisé à un signal d'horloge Hs. Le circuit 3 est par exemple une bascule S-C déclenchée par les fronts montants de l'horloge Hs. La bascule synchrone 3 reçoit le signal RS sur son entrée S (Set) et un signal inverse /RS sur son entrée C (Clear), par l'intermédiaire d'une porte inverseuse 4. Le signal RSs est prélevé sur la sortie Q de la bascule S-C.

La figure 2 représente les signaux RS, Hs et RSs du générateur 1, et la figure 3 représente les fluctuations du bruit N relativement à la tension de référence Vref. Le signal RS oscille de façon aléatoire entre la valeur logique 0 et la valeur logique 1 (tension de saturation de l'amplificateur 2), en fonction de l'amplitude du bruit N relativement à la tension de référence Vref. Comme le bruit N est essentiellement aléatoire, le signal RS est également aléatoire. A chaque front 5 de l'horloge Hs, le signal synchronisé RSs recopie la valeur du signal RS et conserve cette valeur jusqu'au front d'horloge suivant. Le signal RSs est ainsi une séquence de bits aléatoire, synchronisée à l'horloge Hs, par exemple la séquence "11010110001" représentée en figure 2.

La pratique montre que le générateur 1 de la figure 1 présente divers inconvénients, tenant d'une part à la consommation électrique du comparateur 2 et, d'autre part, à la difficulté de compenser les dérives de tension apparaissant dans l'amplificateur 2 en fonction de la température. Comme illustré par la figure 4, ces dérives conduisent l'amplificateur 2 à décaler le bruit N vis-à-vis de la tension de référence Vref, de sorte que le signal RS peut se retrouver bloqué sur la valeur 1 ou 0.

La demande de brevet FR 2 390 047 décrit un générateur de signal aléatoire dans lequel on compare l'amplitude d'un bruit électronique avec une tension de référence, pour produire un signal logique de largeur d'impulsion aléatoire. Ce principe de fonctionnement est conforme à celui qui vient d'être décrit.

Ainsi, un objectif de la présente invention est de prévoir un moyen pour transformer un bruit électronique en signal logique aléatoire, qui présente une bonne stabilité de fonctionnement et une faible sensibilité à la température.

Un objectif plus particulier de l'invention est que ce moyen présente une faible consommation électrique et soit simple à réaliser.

Pour atteindre ces objectifs, l'idée de la présente invention est de convertir un bruit électronique en un décalage temporel de deux signaux pulsés issus d'un même signal pulsé de référence, puis de convertir le décalage temporel en un signal logique.

Le brevet US 4 183 088 décrit un générateur de signal aléatoire comprenant 14 générateurs aléatoires dont les sorties sont appliquées sur les 14 entrées d'un registre à décalage. Le contenu du registre à décalage, à savoir des bits aléatoires, est comparé bit à bit avec le contenu d'un registre à décalage de référence, pour produire un signal aléatoire. Le fonctionnement de chacun des 14 générateurs aléatoires repose sur le principe décrit plus haut. On y trouve en outre une étape de comparaison de signaux pulsés, mais ces signaux pulsés ne sont pas issus du même signal pulsé de référence.

Ainsi, essentiellement, la présente invention prévoit un générateur de signal aléatoire agencé pour transformer un bruit électronique en un signal logique dont la valeur dépend des fluctuations aléatoires du bruit électronique, comprenant des moyens pour transformer au moins un bruit électronique en un décalage temporel d'au moins deux signaux pulsés issus d'un même signal pulsé de référence, et des moyens pour délivrer un signal logique dont la valeur est fonction du décalage relatif des deux signaux pulsés.

Selon un mode de réalisation, les moyens pour transformer au moins un bruit électronique comprennent au moins deux lignes à retard ayant des constantes de temps initialement équilibrées, recevant en entrée le signal pulsé de référence, et des moyens pour injecter au moins un bruit électronique dans au moins l'une des lignes à retard, de manière à faire fluctuer sa constante de temps.

Selon un mode de réalisation, les lignes à retard comprennent des portes logiques en cascade, et au moins une porte logique d'au moins une ligne à retard reçoit un bruit électronique faisant fluctuer sa constante de temps de commutation.

Selon un mode de réalisation, le bruit électronique est appliqué sur la borne de masse ou la borne d'alimentation de la porte logique.

Selon un mode de réalisation, le bruit électronique est appliqué sur la borne de masse d'une capacité tampon connectée à la sortie de la porte logique.

Avantageusement, le bruit électronique est un bruit différentiel prélevé en deux points d'un plan de masse.

Avantageusement, le bruit électronique est un bruit différentiel prélevé en deux points d'un plan d'alimentation électrique.

Selon un mode de réalisation, le générateur comprend au moins deux oscillateurs distincts pour délivrer deux signaux oscillants non corrélés, les signaux oscillants sont injectés en tant que bruit complémentaire dans les lignes à retard.

Selon un mode de réalisation, la sortie de l'une des lignes à retard est ramenée sur son entrée par l'intermédiaire de portes logiques pour former un oscillateur délivrant le signal pulsé de référence.

Selon un mode de réalisation, le générateur comprend des moyens pour échantillonner le signal logique au rythme d'un signal de synchronisation.

Ces objets, caractéristiques et avantages ainsi que d'autres de la présente invention seront exposés plus en détail dans la description suivante de divers exemples de réalisation d'un générateur aléatoire selon l'invention, faite à titre non limitatif en relation avec les figures jointes parmi lesquelles :
- la figure 1 précédemment décrite est le schéma électronique d'un générateur aléatoire classique,
- la figure 2 précédemment décrite représente des signaux présents dans le générateur de la figure 1,
- les figures 3 et 4 précédemment décrites représentent un bruit électronique et une tension de référence appliqués au générateur de la figure 1,
- la figure 5 représente sous forme de blocs un générateur aléatoire selon l'invention,
- la figure 6 représente divers signaux apparaissant dans le générateur de la figure 5,
- les figures 7 à 10 représentent des exemples de réalisation de lignes à retard selon l'invention, représentées sous forme de blocs en figure 5, et.
- la figure 11 est le schéma électrique d'un élément du générateur de la figure 5.

La figure 5 représente un générateur 10 de signal aléatoire RS selon l'invention. Comme on l'a indiqué plus haut, l'idée de la présente invention est de convertir un bruit électronique en un décalage temporel de deux signaux pulsés issus d'un même signal pulsé de référence, puis de convertir le décalage temporel en un signal logique.

Le générateur 10 comprend ainsi deux lignes à retard 11 et 12 recevant en entrée un signal pulsé de référence Hr et délivrant chacune un signal S1, respectivement S2, ayant un temps de retard T sur le signal Hr. Initialement, les lignes à retard 11, 12 sont équilibrées et présentent chacune la même constante de temps T. Ainsi, normalement, les signaux S1 et S2 sont synchrones et recopient le signal Hr avec un même retard T. Selon l'invention, un bruit N est injecté dans au moins l'une des lignes à retard, par exemple la ligne 12, de manière à modifier sa constante de temps d'une valeur Δt aléatoire, positive ou négative selon l'amplitude du bruit N.

Les signaux pulsés S1, S2, décalés par l'injection du bruit N dans la ligne 12, sont envoyés respectivement sur les entrées IN1, IN2 d'un circuit 13. Le circuit 13 délivre sur sa sortie OUT un signal logique RS dont la valeur instantanée est fonction du sens de décalage des signaux S1, S2. De façon optionnelle, le signal aléatoire RS est ensuite échantillonné au rythme d'un signal horloge Hs, par une bascule 14 de type S-C dont la sortie Q délivre un signal aléatoire synchronisé RSs, ou aléa.

Le fonctionnement du générateur aléatoire 10 est illustré par la figure 6 qui représente les signaux Hr, S1, S2, RS, Hs et RSs. On voit que le signal S2 délivré par la ligne 12 (soumise au bruit N) est parfois en avance de +Δt, parfois en retard de -Δt sur le signal S1. Le circuit 13 se déclenche à chaque réception d'une impulsion de l'un des signaux S1 ou S2. Quand une impulsion S1 est reçue avant une impulsion S2, le circuit 13 met sa sortie OUT à 1 (signal RS). Quand une impulsion S1 est reçue avant une impulsion S2, le circuit 13 met sa sortie à 0. Le signal RS est donc un signal aléatoire dont la valeur dépend du sens de décalage des signaux S1, S2. Le signal synchronisé RSs recopie le signal RS à chaque front montant de l'horloge d'échantillonnage Hs.

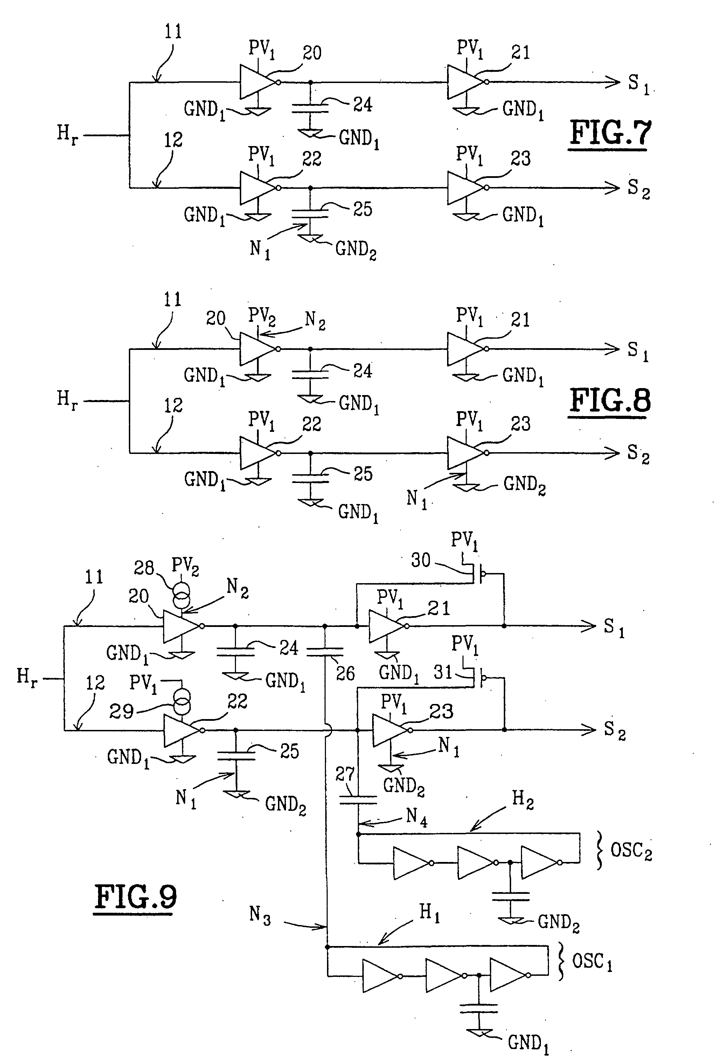

On va maintenant décrire, en relation avec les figures 7 à 9, un exemple simple de réalisation des lignes a, retard 11, 12, et des exemples d'injection de bruit dans au moins l'une des lignes à retard.

Sur la figure 7, les lignes 11 et 12 comprennent chacune deux portes inverseuses en cascade, respectivement 20, 21 et 22, 23, et sont rigoureusement identiques. La porte 20 est rigoureusement identique, dans les limites de la technologie de fabrication, à la porte 22, et la porte 21 rigoureusement identique à la porte 23. La sortie de la porte 20 est connectée à une borne d'une capacité tampon 24 dont l'autre borne est connectée à la masse. Cette capacité 24 s'ajoute à la capacité parasite de sortie de la porte 20 et permet de calibrer la constante de temps T de la ligne 11. A la sortie de la porte 22 de la ligne 12 est disposée une capacité tampon 25 rigoureusement identique à la capacité 24. Les portes 20 à 23 sont alimentées par une tension Vcc prélevée en un même point PV1 d'un plan d'alimentation et sont connectées à un même point de masse GND1 d'un plan de masse. La borne de masse de la capacité 24 est connectée au point de masse GND1 alors que la borne de masse de la capacité 25 est connectée à un autre point de masse GND2, prélevé en un autre endroit du plan de masse.

Selon l'invention, un bruit électronique différentiel N1 est injecté sur la borne de masse de la capacité 25. Le bruit N1 est ici égal à la différence de tension entre les points de masse GND2 et GND1, et provoque un déséquilibre aléatoire des constantes de temps des deux lignes à retard 11, 12. Les signaux pulsés S1, S2 en sortie des lignes 11, 12 se trouvent décalés aléatoirement, comme illustré en figure 6.

Un autre exemple d'injection de bruit est illustré sur la figure 8. Sur cette figure, tous les éléments sont connectés au point de masse GND1 à l'exception de la porte 23 de la ligne 12, qui a sa borne de masse connectée au point de masse GND2. Le bruit différentiel N1 est. donc injecté ici sur la masse de la porte 23, et modifie aléatoirement la tension de seuil VTN23 de commutation basse (passage à 0) de cette porte. La modification aléatoire de la tension de seuil VTN23 se traduit par un déséquilibre aléatoire de la constante de temps de la ligne 12. De plus, toutes les portes logiques ont leur borne d'alimentation connectée au point PV1 du plan d'alimentation, à l'exception de la porte 20 qui a sa borne d'alimentation connectée à un autre point d'alimentation PV2, prélevé en un autre endroit du plan d'alimentation. Un bruit différentiel N2 est donc injecté sur l'alimentation de la porte 20 et modifie aléatoirement sa tension de seuil VTP20 de commutation haute (passage à 1), ce qui entraîne un déséquilibre temporel supplémentaire entre les lignes 11 et 12.

Selon le mode de réalisation représenté en figure 9, on combine les injections de bruits N1 et N2 qui viennent d'être décrites. Ainsi, les bornes de masse de la porte 23 et de la capacité 25 reçoivent le bruit N1 et la borne d'alimentation de la porte 20 reçoit le bruit N2. En outre, une capacité 26 est ajoutée en parallèle avec la capacité 24 de la ligne 11 et une capacité 27 est ajoutée en parallèle avec la capacité 25 de la ligne 12. Les capacités 26 et 27 sont identiques mais reçoivent sur leur borne de masse des signaux oscillants H1, H2 délivrés par des oscillateurs OSC1, OSC2 différents ayant des fréquences propres différentes. Ainsi, le signal H1 injecte dans la ligne 11 un bruit supplémentaire N3 et le signal H2 injecte dans la ligne 12 un bruit supplémentaire N4. Le bruit différentiel résultant est un bruit cyclique non aléatoire qui présente toutefois un temps de cycle assez long (multiple des fréquences propres des deux oscillateurs OSC1, OSC2).

En pratique, les lignes à retard selon l'invention peuvent faire l'objet de diverses autres variantes de réalisation et perfectionnements. En particulier, bien que les lignes à retard 11, 12 représentées sur les figures 7 à 9 ne comportent que deux portes inverseuses en cascade dans un souci de simplicité de la description, il est bien évident que ce nombre peut être augmenté et choisi en fonction de la constante de temps que l'on souhaite obtenir et des caractéristiques de commutation des portes logiques. De plus, de multiples points d'injection de bruit peuvent être prévus.

Par ailleurs, il convient de noter que la réalisation des lignes à retard 11, 12 au moyen de portes logiques, notamment de portes CMOS, permet de maîtriser la consommation du générateur 10 selon l'invention. Par exemple, les portes 20 et 22 dont les sorties attaquent les capacités 24, 26 et 25, 27 peuvent être alimentées par l'intermédiaire de générateurs de courant 28, 29 à faible débit, comme illustré en figure 9 (on peut également dimensionner la taille du drain du transistor PMOS qu'elle comporte de manière à limiter le courant de commutation). Egalement, étant donné que les portes CMOS ne consomment du courant qu'à la commutation, des transistors PMOS 30, 31 montés en accélérateurs de commutation peuvent être prévus entre les sorties des portes 21 et 23 et leurs entrées, comme illustré en figure 9.

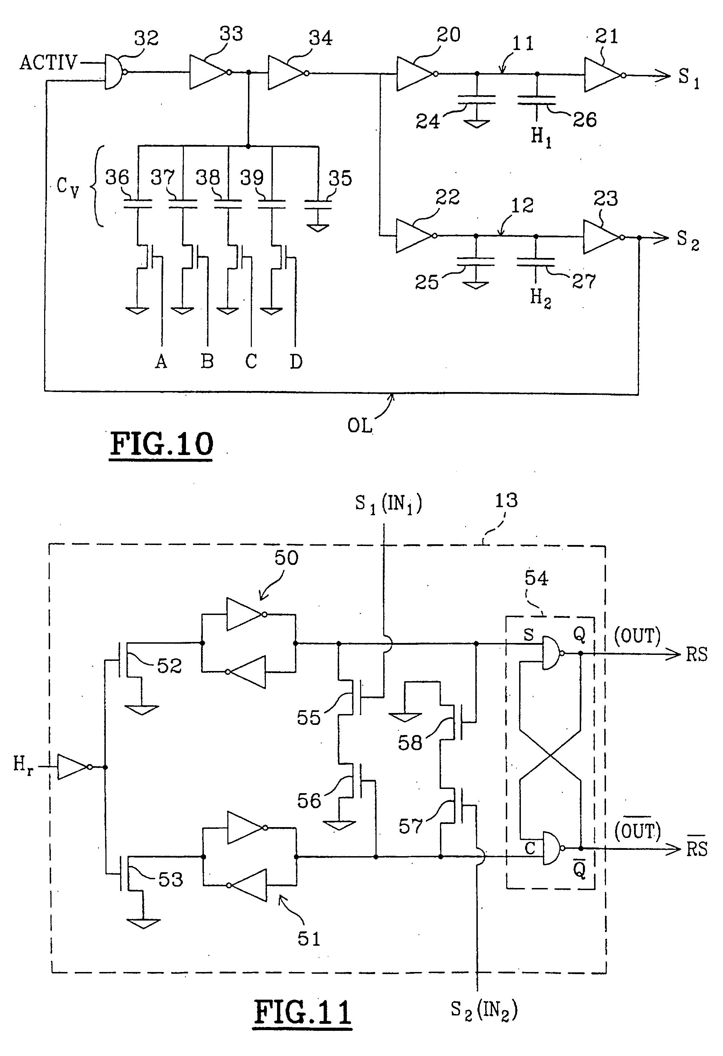

Enfin, selon un mode de réalisation avantageux représenté sur la figure 10, l'une des lignes à retard, ici la ligne 12, a sa sortie ramenée sur son entrée par l'intermédiaire de portes inverseuses 32, 33, 34 en cascade. L'ensemble forme une boucle d'oscillateur OL permettant de générer *in situ* le signal de référence Hr appliqué à l'entrée des lignes 11, 12. Sur la figure 10, la sortie de la ligne 12 est ramenée en entrée par l'intermédiaire d'une porte NON ET 32 pilotée par un signal d'activation ACTIV du générateur, et de deux portes inverseuses 33, 34. Le nombre total de portes inverseuses de la boucle d'oscillateur OL doit être, de façon classique, impair.

Par ailleurs, la sortie d'une porte inverseuse de la boucle OL, par exemple la porte 33, comporte à sa sortie une capacité tampon Cv variable. La capacité Cv comprend en parallèle une capacité 35 et des capacités 36 à 39 commutables au moyen de transistors MOS pilotés par des signaux A, B, C, D. Ces signaux peuvent être prélevés en tout point d'un circuit intégré, par exemple dans un bus d'adresses ou de données, ou à la sortie du générateur 10. La modification de la capacité Cv entraîne une modification de la fréquence de résonance de la boucle d'oscillateur OL.

La figure 11 représente un mode de réalisation du circuit 13 de la figure 5. Le circuit 13 comprend deux inverseurs à mémoire 50, 51 dont les entrées sont connectées à la masse par l'intermédiaire de deux transistors 52, 53, respectivement. Le signal de référence Hr commande les transistors 52, 53 par l'intermédiaire d'une porte inverseuse. Les sorties des inverseurs 50, 51 attaquent respectivement l'entrée S et l'entrée C d'une bascule 54 de type S-C. La sortie Q de la bascule 54 délivre le signal RS et la sortie /Q délivre le signal inverse /RS. La sortie de l'inverseur 50 est connectée à la masse par l'intermédiaire de deux transistors 55, 56 en série. Le transistor 55 est piloté par le signal S1 et le transistor 56 est piloté par la sortie de l'inverseur 51. De façon symétrique, la sortie de l'inverseur 51 est connectée à la masse par l'intermédiaire de deux transistors 57, 58. Le transistor 57 est piloté par le signal S2 et le transistor 58 est piloté par la sortie de l'inverseur 50.

Le signal de sortie RS passe à 1 quand la sortie de l'inverseur 50 passe à 0, et passe à 0 quand la sortie de l'inverseur 51 passe à 0. A chaque période du signal de référence Hr, la sortie des inverseurs 50, 51 est mise à 1 par le passage à 0 du signal Hr, qui précède les impulsions des signaux S1, S2. Pendant la période d'attente qui suit, la bascule 54 maintient ainsi la valeur courante du signal RS à la sortie du circuit 13. Si, ensuite, une impulsion S1 apparaît avant une impulsion S2, l'impulsion S1 ferme le transistor 55, la sortie de l'inverseur 50 passe à 0, et le signal RS passe à 1 (ou reste à 1, selon sa valeur précédente). Inversement, si une impulsion S2 apparaît avant une impulsion S1, l'impulsion S2 ferme le transistor 57, la sortie de l'inverseur 51 passe à 0 et le signal RS passe à 0 (ou reste à 0). On voit que la structure du circuit est telle que les sorties des inverseurs à mémoire 50, 51 ne peuvent être simultanément à 0, l'un des transistors 56, 58 étant rendu non conducteur par le premier inverseur dont la sortie est à 0. Les trois états possibles des sorties des inverseurs 50, 51 sont donc :
- "11" : réception d'une impulsion à 0 du signal Hr (phase d'initialisation),
- "01" : réception d'une impulsion S1 avant une impulsion S2, ou
- "10" : réception d'un impulsion S2 avant une impulsion S1,
et correspondent respectivement au maintien de la valeur précédente du signal RS, au passage (ou au maintien) à 1 du signal RS, au passage (ou au maintien) à 0 du signal RS.

Il apparaîtra clairement à l'homme de l'art que la présente invention est susceptible de diverses variantes de réalisation et perfectionnements. En particulier, il existe en pratique diverses méthodes pour obtenir des lignes à retard parfaitement symétriques en l'absence de bruit électronique. Ces méthodes relèvent du savoir-faire de l'homme de l'art et n'ont pas été décrites dans un souci de simplicité. D'autre part, il peut être noté que la prévision de plusieurs paires de lignes à retard en parallèle, ayant chacune leur propre boucle d'oscillateur ou une boucle d'oscillateur commune, permet de délivrer en un coup d'horloge un mot aléatoire comprenant une pluralité de bits en parallèle. Par ailleurs, bien que les lignes à retard selon l'invention aient été présentées comme constituées de portes logiques, il est bien évident que ces lignes à retard peuvent être réalisées de diverses autres manières connues. Enfin, il convient de noter que le générateur aléatoire selon l'invention, en raison de sa simplicité et de sa faible consommation de courant, convient particulièrement bien aux circuits intégrés des cartes à puce, notamment aux circuits intégrés des cartes à puce sans contact alimentés par induction électromagnétique et possédant de faibles ressources énergétiques.

## Revendications

1. Générateur (10) de signal aléatoire agencé pour transformer un bruit électronique (N, N1, N2) en un signal logique (RS) dont la valeur dépend des fluctuations aléatoires du bruit électronique (N, N1, N2), **caractérisé en ce qu'**il comprend :
- des moyens (11, 12) pour transformer au moins un bruit électronique (N, N1, N2) en un décalage temporel d'au moins deux signaux pulsés (S1, S2) issus d'un même signal pulsé de référence (Hr), et
- des moyens (13) pour délivrer un signal logique (RS) dont la valeur est fonction du décalage temporel relatif (+Δt, -Δt) des deux signaux pulsés (S1, S2).

2. Générateur (10) selon la revendication 1, dans lequel les moyens pour transformer au moins un bruit électronique comprennent :
- au moins deux lignes à retard (11, 12) ayant des constantes de temps (T) initialement équilibrées, recevant en entrée ledit signal pulsé de référence (Hr),
- des moyens (20, 22, 23, 25) pour injecter au moins un bruit électronique (N, N1, N2) dans au moins l'une des lignes à retard (11, 12), de manière à faire fluctuer sa constante de temps (T).

3. Générateur selon la revendication 2, dans lequel :
- les lignes à retard (11, 12) comprennent des portes logiques (20-23) en cascade, et
- au moins une porte logique (20, 22, 23) d'au moins une ligne à retard (11, 12) reçoit au moins un bruit électronique (N1, N2) faisant fluctuer sa constante de temps de commutation.

4. Générateur selon la revendication 3, dans lequel le bruit électronique (N1, N2) est appliqué sur la borne de masse ou la borne d'alimentation de la porte logique (20, 23).

5. Générateur selon l'une des revendications 3 et 4, dans lequel le bruit électronique (N1) est appliqué sur la borne de masse d'une capacité tampon (25) connectée à la sortie de la porte logique (22).

6. Générateur selon l'une des revendications précédentes, **caractérisé en ce que** le bruit électronique (N1, N2) est un bruit différentiel prélevé en deux points (GND1, GND2) d'un plan de masse.

7. Générateur selon l'une des revendications précédentes, **caractérisé en ce que** le bruit électronique (N1, N2) est un bruit différentiel prélevé en deux points (PV1, PV2) d'un plan d'alimentation électrique.

8. Générateur selon l'une des revendications 2 à 7, **caractérisé en ce qu'**il comprend au moins deux oscillateurs distincts (OSC1, OSC2) pour délivrer deux signaux oscillants (H1, H2) non corrélés, et **en ce que** lesdits signaux oscillants sont injectés en tant que bruit complémentaire (N3, N4) dans les lignes à retard.

9. Générateur selon l'une des revendications 2 à 8, dans lequel la sortie de l'une des lignes à retard (12) est ramenée sur son entrée par l'intermédiaire de portes logiques (32, 33, 34) pour former un oscillateur délivrant ledit signal pulsé de référence (Hr).

10. Générateur (1) selon l'une des revendications précédentes, comprenant des moyens pour échantillonner le signal logique (RS) au rythme d'un signal de synchronisation (Hs).

## Patentansprüche

1. Generator (10) von Zufallssignalen zur Übertragung eines elektronischen Rauschens (N, N1, N2) in einem Logik-Signal (RS), dessen Wert von den zufälligen Schwankungen des elektronischen Rauschens (N, N1, N2) abhängt,
**dadurch gekennzeichnet, dass**
er umfasst:
- Mittel (11, 12) zur Übertragung von mindestens einem elektronischen Rauschen (N, N1, N2) in einer zeitlichen Verschiebung um mindestens zwei gepulste Signale (S1, S2), die aus dem gleichen gepulsten Referenzsignal (Hr) stammen, und
- Mittel (13) zur Aussendung eines Logik-Signals (RS), dessen Wert eine Funktion der zeitlichen Relativverschiebung (+Δt, -Δt) der beiden gepulsten Signale (S1, S2) ist.

2. Generator (10) gemäß Anspruch 1, worin die Mittel zur Übertragung von mindestens einem elektronischen Rauschen umfassen:
- mindestens zwei Laufzeitketten (11, 12), die Zeitkonstanten (T) aufweisen, die anfänglich im Gleichgewicht sind und am Eingang das genannte gepulste Referenzsignal (Hr) empfangen,
- Mittel (20, 22, 23, 25) zur Injektion von mindestens einem elektronischen Rauschen (N, N1, N2) in mindestens eine der Laufzeitketten (11, 12), und zwar so, dass man ihre Zeitkonstante (T) schwanken lässt.

3. Generator gemäß Anspruch 2, worin:
- die Laufzeitketten (11, 12) Logik-Tore (20 bis 23) in Kaskade umfassen, und
- mindestens ein Logik-Tor (20, 22, 23) der mindestens einen Laufzeitkette (11, 12) mindestens ein elektronisches Rauschen (N1, N2) empfängt, das ihre Schaltungszeitkonstante schwanken lässt.

4. Generator gemäß Anspruch 3, worin das elektronische Rauschen (N1, N2) an den Masse-Anschluss oder den Stromanschluss des Logik-Tores (20, 23) angelegt wird.

5. Generator gemäß einem der Ansprüche 3 und 4, worin das elektronische Rauschen (N1) an den Masse-Anschluss eines Kapazitätspuffers (25) angelegt wird, der an den Ausgang des Logik-Tores (22) angeschlossen wird.

6. Generator gemäß einem der vorhergehenden Ansprüche,
**dadurch gekennzeichnet, dass**
das elektronische Rauschen (N1, N2) ein differenzielles Rauschen ist, das an zwei Punkten (GND1, GND2) eines Masse-Plans aufgenommen wird.

7. Generator gemäß einem der vorhergehenden Ansprüche,
**dadurch gekennzeichnet, dass**
das elektronische Rauschen (N1, N2) ein differenzielles Rauschen ist, das an zwei Punkten (PV1, PV2) eines elektrischen Stromplans aufgenommen wird.

8. Generator gemäß einem der Ansprüche 2 bis 7,
**dadurch gekennzeichnet, dass**
er mindestens zwei unterschiedliche Oszillatoren (OSC1, OSC2) zur Aussendung von zwei Oszilliersignalen (H1, H2) umfasst, die nicht korreliert sind, und dass die genannten Oszilliersignale als Ergänzungsrauschen (N3, N4) in die Laufzeitketten injiziert werden.

9. Generator gemäß einem der Ansprüche 2 bis 8, worin der Ausgang der einen Laufzeitkette (12) auf seinen Eingang über das Zwischenstück der Logik-Tore (32, 33, 34) zur Bildung eines Oszillators, der das genannte gepulste Referenzsignal (Hr) aussendet, zurückgeleitet wird.

10. Generator (1) gemäß einem der vorhergehenden Ansprüche, der Mittel zur Eichung des Logik-Signals (RS) im Rhythmus eines Synchronisationssignals (Hs) umfasst.

## Claims

1. Random signal generator (10) designed to transform electronic noise (N, N1, N2) into a logic signal (RS) of which the value depends on random fluctuations of the electronic noise (N, N1, N2), **characterised in that** it comprises:
- means (11, 12) for transforming at least one electronic noise (N, N1, N2) into a time shift of at least two pulsed signals (S1, S2) coming from a single pulsed reference signal (Hr), and
- means (13) for delivering a logic signal (RS) of which the value is a function of the relative time shift (+Δt, - Δt) of the two pulsed signals (S1, S2).

2. Generator (10) according to Claim 1, in which the means for transforming at least one electronic noise comprise:
- at least two delay lines (11, 12) having time constants (T) initially balanced, receiving as an input the said pulsed reference signal (Hr),
- means (20, 22, 23, 25) for injecting at least one electronic noise (N, N1, N2) into at least one of the delay lines (11, 12), in such a way as to cause its time constant (T) to fluctuate.

3. Generator according to Claim 2, in which:
- the delay lines (11, 12) have logic ports (20-23) in cascade, and
- at least one logic port (20, 22, 23) of at least one delay line (11, 12) receives at least one electronic noise (N1, N2) causing its commutation time constant to fluctuate.

4. Generator according to Claim 3, in which the electronic noise (N1, N2) is applied to the earth terminal or the supply terminal of the logic port (20, 23).

5. Generator according to one of Claims 3 and 4, in which the electronic noise (N1) is applied to the earth terminal of a buffer capacitor (25) connected to the output of the logic port (22).

6. Generator according to one of the foregoing Claims, **characterised in that** the electronic noise (N1, N2) is a differential noise sampled at two points (GND1, GND2) of an earth plane.

7. Generator according to one of the foregoing Claims, **characterised in that** the electronic noise (N1, N2) is a differential noise sampled at two points of (PV1, PV2) of an electric supply plane.

8. Generator according to one of Claims 2 to 7, **characterised in that** it includes at least two distinct oscillators (OSC1, OSC2) for delivering two non-related oscillatory signals (H1, H2), and **in that** the said oscillatory signals are injected in the form of complementary noise (N3, N4) in the delay lines.

9. Generator according to one of Claims 2 to 8, in which the output of one of the delay lines (12) is fed back to its input through the intermediary of logic ports (32, 33, 34) for forming an oscillator delivering the said pulsed reference signal (Hr).

10. Generator (1) according to one of the foregoing Claims, including means for sampling the logic signal (RS) at the rhythm of a synchronisation signal (Hs).
